(19) Europäisches Patentamt
European Patent Office
Office européen des brevets

(11) EP 3 370 270 A1

(12) EUROPEAN PATENT APPLICATION
published in accordance with Art. 153(4) EPC

(43) Date of publication:
05.09.2018 Bulletin 2018/36

(51) Int Cl.:
H01L 35/12 (2006.01)    H01L 35/32 (2006.01)
H01L 35/02 (2006.01)    H01L 35/30 (2006.01)

(21) Application number: 16860186.2

(22) Date of filing: 26.10.2016

(86) International application number:
PCT/KR2016/012059

(87) International publication number:
WO 2017/074003 (04.05.2017 Gazette 2017/18)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 27.10.2015  KR 20150149397
21.07.2016  KR 20160092678
20.10.2016  KR 20160136488

(71) Applicants:
• Korea Advanced Institute of Science and
Technology
Daejeon 34141 (KR)
• Tegway Co., Ltd.
Daejeon 34051 (KR)

(72) Inventors:
• CHO, Byung Jin
Daejeon 34124 (KR)
• KIM, Sun Jin
Daejeon 34138 (KR)
• SHIN, Ji Seon
Daejeon 34185 (KR)
• YIM, Sehwan
Daejeon 34141 (KR)
• CHOI, Hyeong Do
Daejeon 34141 (KR)
• KIM, Yongjun
Daejeon 34141 (KR)
• KIM, Choong Sun
Daejeon 34141 (KR)
• WE, Ju Hyung
Daejeon 34141 (KR)

(74) Representative: D Young & Co LLP
120 Holborn
London EC1N 2DY (GB)

(54) FLEXIBLE THERMOELECTRIC DEVICE AND METHOD FOR PREPARING SAME

(57)    The present invention relates to a flexible thermoelectric element and a production method therefor, the flexible thermoelectric element comprising: a thermoelectric material column array including one or more N-type thermoelectric material and one or more P-type thermoelectric material which are spaced apart from each other; an electrode configured to electrically connect the thermoelectric materials of the thermoelectric material column array; and a foam configured to fill in at least a void of the thermoelectric material column array.

FIG. 2

**Description**

[Technical Field]

The present invention relates to a flexible thermoelectric element and a production method therefor, and more particularly, to a flexible thermoelectric element having high flexibility and mechanical stability, high adhesive strength between internal components, and a production method therefor.

[Background Art]

A thermoelectric effect is an effect in which thermal energy and electric energy are directly converted into each other through interaction and is a generic term for the Seebeck effect discovered by Thomas Johann Seebeck and the Peltier effect discovered by Jean Charles Peltier. A device exhibiting such a thermoelectric effect is referred to as a thermoelectric device.

The thermoelectric device includes a thermoelectric power generating device using the Seebeck effect which converts thermal energy into electrical energy, and a cooling device using the Peltier effect which converts electrical energy into thermal energy, and the like. The thermoelectric device is a material and a technique which best meets the demands of energy saving. It is widely used in fields such as automobile industry, aerospace industry, semiconductor industry, biotechnology industry, optic industry, computer industry, power generation industry, household appliance industry, and the like, and efforts to improve thermal efficiency are being conducted by research institutes and universities.

Generally, a thermoelectric device(a thermoelectric element) is manufactured by forming a second electrode on a ceramic lower substrate such as alumina ($Al_2O_3$), forming a thermoelectric material made of N-type and P-type semiconductors on a surface of the second electrode, and connecting the N-type thermoelectric material and the P-type thermoelectric material in series through a first electrode. However, such a thermoelectric device is either a cascade type thermoelectric device or a segment type thermoelectric device, and thus it is difficult to change a shape of the thermoelectric device, and a ceramic substrate made of alumina ($Al_2O_3$) or alumina nitride (AIN) or a metal substrate coated with a nonconductor thin film, which have no flexible characteristic, is used such that it is difficult to apply the thermoelectric device to fields demanding flexibility.

Further, a weight of the substrate is heavy and thus the thermoelectric device is not suitable for fields of a physical fitness body field, an automobile field, an aerospace field, and the like, which demand weight reduction, and the P type and N type thermoelectric materials are formed in a bulky shape to have lengths in the range of 1 mm to several tens of millimeters, but a heat loss due to upper and lower substrates is large.

Furthermore, Korean Patent Registration No. 10-1646366 disclosed a thermoelectric module structure in which silicone is poured and a P-type pellet and an N-type pellet are inserted into the poured portion to improve durability against vibration. However, in such a case, since the silicone is located between an electrode and a thermoelectric material thus causing thermal conductivity to increase, it is difficult to secure a temperature difference between both ends of the thermoelectric device, and also there is a fatal problem in that heat loss occurs moving from the thermoelectric material toward the silicone and thus performance of the thermoelectric device is degraded, and due to a characteristic of the silicone which is an inorganic material, attempting to secure flexibility of a curved portion by providing grooves at the silicone has a disadvantage in that overall flexibility of the thermoelectric device is degraded.

Meanwhile, the applicant of the present invention has disclosed in Korean Patent Registration No. 10-1493797 has been proposed that a substrate is not located on an upper portion and/or a lower portion of a thermoelectric device and a nonconductive flexible mesh that is supported passing through a thermoelectric material column array such that mechanical stability and flexibility can be simultaneously secured.

The disclosed thermoelectric device has a characteristic of high power generation and high flexibility, but due to a polymer material filling in a space between an N-type thermoelectric material and a P-type thermoelectric material of the thermoelectric device so as to secure mechanical stability, thermal conductivity between an electrode and the thermoelectric materials increases and thus heat loss occurs, such that there is a problem in that the heat-electricity conversion efficiency is somewhat degraded.

Accordingly, it is urgently required to develop a flexible thermoelectric element having high heat-electricity conversion efficiency by significantly lowering thermal conductivity while securing high flexibility and high mechanical stability.

[Technical Problem]

The present invention is directed to providing a flexible thermoelectric element having very high heat-electricity conversion efficiency using an intermediate filler material that has remarkably low thermal conductivity in addition to having high flexibility and mechanical stability, and high adhesive strength between internal components, and a production method therefor.

[Technical Solution]

According to one aspect of the present invention, there is provided a flexible thermoelectric element including thermoelectric material column arrays, each of which includes one or more N-type thermoelectric materials and one or more P-type thermoelectric material which are spaced apart from each other, an electrode configured to electrically connect the thermoelectric materials of the thermoelectric material column array, and a foam configured to fill in at least a void of the thermoelectric material column array.

According to another aspect of the present invention, there is provided a production method for a flexible thermoelectric element, which includes a) forming a first structure in which a first sacrificial substrate, a first contact thermal conductor layer, a first electrode, and a P-type thermoelectric material formed at a predetermined region on the first electrode are sequentially stacked, and a second structure in which a second sacrificial substrate, a second contact thermal conductor layer, a second electrode, and an N-type thermoelectric material formed at a predetermined region on the second electrode are sequentially stacked, b) manufacturing a substrate having the thermoelectric material column arrays formed thereon by physically connecting the first structure and the second structure, c) forming a foam in a void of the thermoelectric material column array of the substrate, and d) removing the first sacrificial substrate and the second sacrificial substrate.

[Advantageous Effects]

A flexible thermoelectric element according to one embodiment of the present invention can have remarkably low thermal conductivity using a foam as a filling material for filling a void of a thermoelectric material column array, thereby remarkably improving a temperature gradient of the flexible thermoelectric element and efficiency of thermoelectric power generation.

Further, weight reduction of the flexible thermoelectric element can be achieved due to a foam structure, and the flexible thermoelectric element can have high flexibility as well as absorb an externally applied physical impact due to a high elasticity property, such that the flexible thermoelectric element can be prevented from being damaged by the physical impact and high mechanical stability can be secured.

Furthermore, there is an advantage in that adhesive strength between a foam and an electrode and between the foam and a thermoelectric material is high, and thus glass frit, which is necessarily added to the electrode or the thermoelectric material so as to improve adhesive strength, can be excluded. As described above, since glass frit having low electrical conductivity can be excluded, the efficiency of the thermoelectric power generation of the flexible thermoelectric element can further be improved, and also since the electrode or the thermoelectric material can be formed without using a paste, a manufacturing process of the flexible thermoelectric element can be significantly simplified.

Specifically, since a polyurethane foam is used as the foam, the adhesive strength between the foam and the electrode and between the foam and the thermoelectric material can be significantly improved while high flexibility and high mechanical stability can also be ensured, and a filling material can have a significantly low thermal conductivity of 0.05 W/m.K or less which is a level approaching a thermal conductivity of air.

[Description of Drawings]

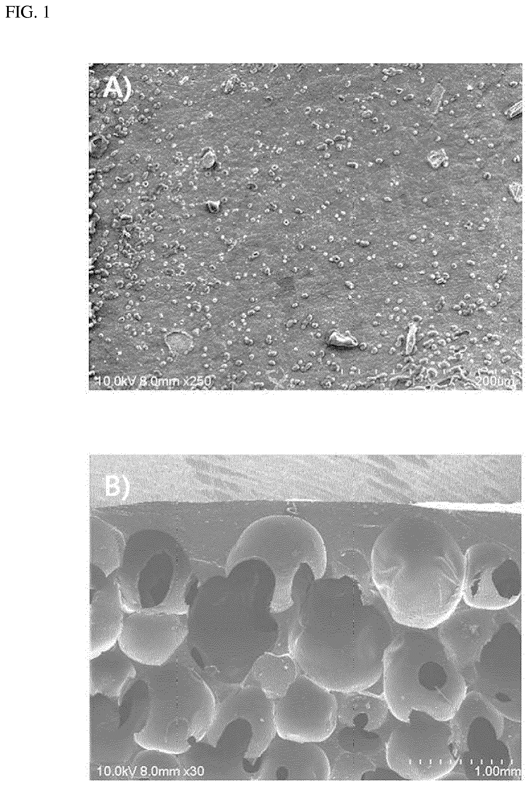

A of FIG. 1 is a photograph illustrating one surface of a polyurethane foam adhered to an electrode wherein it can be seen that a dense polyurethane film is formed, and B of FIG. 1 is a photograph illustrating an inner cross section of the polyurethane foam wherein it can be seen that polyurethane is foamed to have a pore structure.

FIG. 2 is a cross-sectional view of a flexible thermoelectric element according to one embodiment of the present invention.

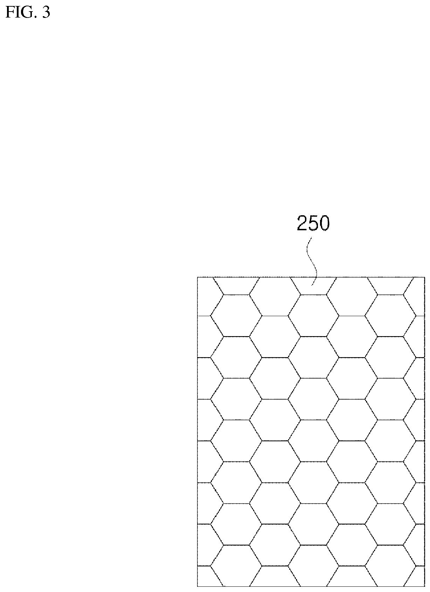

FIG. 3 is a diagram illustrating a pore structure of a foam according to one embodiment of the present invention, and an example of the pore structure of the foam may be a honeycomb structure.

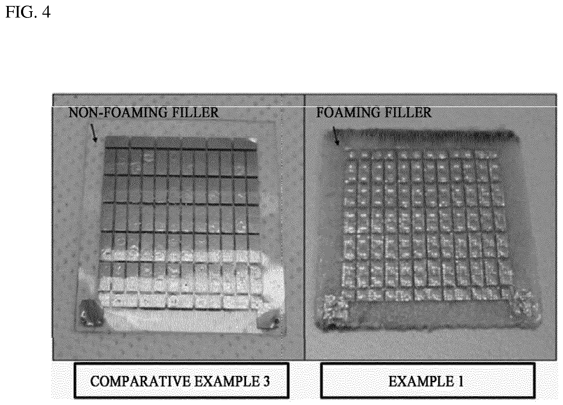

FIG. 4 is actual photographs of flexible thermoelectric elements manufactured according to Example 1 and Comparative Example 3.

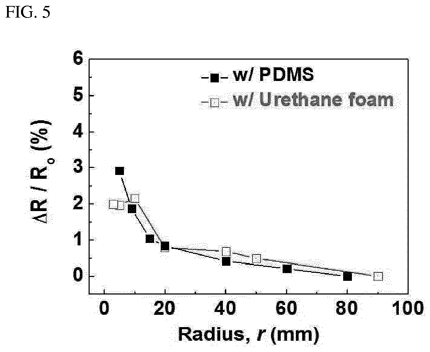

FIG. 5 is a graph measuring a rate of variation by percentage in internal resistance of the flexible thermoelectric element according to a radius curvature thereof, which is manufactured according to Example 1 and Comparative Example 3.

FIG. 6 is a schematic flowchart of a production method of a flexible thermoelectric element according to one embodiment of the present invention.

FIG. 7 is a photograph illustrating an example in which the flexible thermoelectric element according to one embodiment of the present invention is applied in a real life situation.

[Description of Reference Numerals]

200 and 300: flexible thermoelectric element
210, 210', 310, and 310': contact thermal conductive layers
220 and 320: first electrodes
220' and 320': second electrodes
230 and 330: P-type thermoelectric materials
240 and 340: N-type thermoelectric materials
250 and 350: foams
301 and 301': sacrificial substrate
302 and 302': sacrificial film

[Modes of the Invention]

A flexible thermoelectric element of the present invention will be described in detail below with reference to the accompanying drawings. The following drawings are provided as examples so as to fully convey the spirit of the present invention to those skilled in the art. Therefore, the present invention is not limited to the following drawings but may be implemented in other forms. The following drawings may be exaggerated in order to clarify the spirit of the present invention. Further, like reference numerals designate like elements throughout the present invention.

At this point, unless otherwise defined in technical and scientific terms used herein, meanings which are commonly understood by those skilled in the art to which the present invention pertains, and descriptions of well-known functions and configurations which may unnecessarily obscure the gist of the present invention in the following description and the accompanying drawings will be omitted.

The applicant of the present invention has disclosed in Korean Patent Registration No. 10-1493797 has been proposed that a substrate is not located on an upper portion and/or a lower portion of a thermoelectric element and a nonconductive flexible mesh is supported passing through a thermoelectric material column array such that mechanical stability and flexibility can simultaneously be secured.

The disclosed thermoelectric element has a characteristic of high power generation and high flexibility, but due to a polymer material filling in a space between an N-type thermoelectric material and a P-type thermoelectric material of the thermoelectric element so as to secure mechanical stability, thermal conductivity between an electrode and the thermoelectric materials increases and thus heat loss occurs, such that there is a problem in that the heat-electricity conversion efficiency is somewhat degraded.

In order to overcome these limitations, research has been conducted for a long period of time on a material capable of having significantly low thermal conductivity, high adhesive strength for an electrode and a thermoelectric material, and high flexibility as a filling material which fills in a void between the electrode and a thermoelectric material column array, and thus it has been found that, when a foam is used as the filling material, low thermal conductivity, high adhesive strength, flexibility, and high mechanical stability can all be secured, such that the present invention has been completed by expanding on the above-described finding.

Specifically, a flexible thermoelectric element according to the present invention may include a thermoelectric material column array containing at least one N-type thermoelectric material and at least one P-type thermoelectric material which are spaced apart from each other, an electrode configured to electrically connect the thermoelectric materials of the thermoelectric material column array, and a foam configured to fill in at least one void between the thermoelectric material column arrays.

The foam is a filling material filling in the void between the thermoelectric pillar arrays, and due to a characteristic of a thermoelectric element, a temperature gradient between an electrode directly in contact with a heat source and an electrode formed to face the above-described electrode (e.g., when a first electrode is in contact with the heat source, an electrode facing the first electrode is a second electrode) is preferable to be large, such that it is preferable that the foam is a material having low thermal conductivity. That is, it is preferable that the foam is a material having flexibility as well as low thermal conductivity and ensuring sufficient mechanical and physical strength by being adhered to the electrode.

More specifically, the foam according to one embodiment of the present invention may be a flexible polymer foam having a plurality of fine pores containing one or more gases selected from among low thermal conductivity air, carbon dioxide, nitrogen, argon, krypton, xenon, and ammonia. The gas such as air, carbon dioxide, nitrogen, argon, krypton, xenon, or ammonia is a representative material having very low thermal conductivity, and when a foam containing such a gas is used as a filling material, the filling material may have very low thermal conductivity and a temperature gradient of a thermoelectric element may significantly be improved, such that efficiency of thermoelectric power generation may significantly be improved. Further, weight reduction of the flexible thermoelectric element may be achieved due to a foam structure, and flexibility as well as elasticity are high and thus an externally applied physical impact may be absorbed, such that the flexible thermoelectric element may be prevented from being damaged by the physical impact and high mechanical stability can be secured.

Specifically, the foam may be a polymer foam. More specifically, the foam may be a flexible polymer foam in the form of a sponge having flexibility and stretchability. Accordingly, the flexible thermoelectric element may have significantly low thermal conductivity and high flexibility, and, at the same time, the foam may also absorb a portion of an external force even when the external force is repeatedly applied, such that damages to the filling material, the electrode, and the thermoelectric material may be prevented and the flexible thermoelectric element may operate stably for a long period of time.

In one embodiment of the present invention, the foam is not particularly limited as long as it is a polymer foam having flexibility and low thermal conductivity, and specifically, for example, the foam may have thermal conductivity of 20% or less relative to the thermoelectric material, and the foam having thermal conductivity in the range of 0.1 to 10% relative to that of the thermoelectric material may be used to effectively block heat transfer and secure thermal stability.

More specifically, the foam according to the present invention may have thermal conductivity of 0.1 W/m.K or less, more preferably 0.08 W/m.K or less, and even more preferably 0.05 W/m.K or less. As described above, since the thermal conductivity is very low, the heat transfer may effectively be blocked and thus the thermal stability may be secured. At this point, a lower limit of the thermal conductivity is not particularly limited, and thermal conductivity of the gas contained in the foam may be considered as the lower limit.

At this point, the foam may be foamed using a conventional foaming method, and any known method may be used as long as it is capable of satisfying physical properties required for the foam in the present invention.

Specifically, the foam may be formed by foaming a foam precursor containing a foaming agent. The foam precursor is not particularly limited as long as it is a material capable of forming a foam having flexibility and low thermal conductivity after foaming, but a material which can satisfy the required properties of an intended foam may be used. Specifically, the foam precursor may be selected in consideration of flexibility, physical strength, degree of foaming, air porosity, and the like of the foam.

The foam precursor for forming such a polymer foam may include a polymer or a prepolymer but is not limited thereto.

That is, the foam may be formed by foaming the polymer or the prepolymer. The prepolymer is a compound containing a curable functional group (curing group) and having a relatively low degree of polymerization and may refer to a prepolymer or a monomer before curing and foaming to fill in the void formed between the thermoelectric material column arrays, and the prepolymer may be partially or entirely cured to form the filling material. That is, a compound in a state before curing to fill in the thermoelectric material column array may be referred to as a prepolymer, and a product obtained by curing or foaming the prepolymer may be referred to as the filling material or the foam. Further, when the foam is formed using a polymer, the polymer may refer to a state before filling in the thermoelectric material column array and being foamed, and the polymer may be formed by polymerizing the prepolymer.

As a specific example, the foam is not particularly limited as long as it is flexible and has low thermal conductivity, and as a non-limiting example, the foam may be a polyurethane-based foam, a silicone-based foam, a polyolefin-based foam, or the like. The usage of the foam as the filling material of the thermoelectric element may effectively block heat transfer between upper and lower electrodes and minimize a heat loss from the thermoelectric material such that thermoelectric efficiency of the thermoelectric element may be improved, flexibility and elasticity are high, a change in physical properties is low according to a temperature, and flexibility is maintained in a wide temperature range, such that the thermoelectric element may not be damaged due to frequent physical deformation and thus a lifetime of the thermoelectric element may be lengthened.

The polyurethane-based foam may be manufactured from a urethane-based foam precursor, and the urethane-based foam precursor may be classified into a first form in which a polymer is formed by an addition condensation reaction of an isocyanate group (-NCO) and a hydroxyl group (-OH) in the presence of a catalyst, and a second form in which a polymer is formed by an addition reaction of a urethane-based prepolymer containing an unsaturated group and a crosslinking agent.

More specifically, the first form may form the polymer as a result of a reaction of a polyisocyanate-based compound containing two or more isocyanate groups with a polyol-based compound containing two or more hydroxy groups.

In one embodiment, the polyisocyanate-based compound may include one or two or more compounds selected from the group consisting of aromatic polyisocyanate, aliphatic polyisocyanate, and alicyclic polyisocyanate. More specifically, the aromatic polyisocyanate may include 1,3-phenylene diisocyanate, 1,4-phenylene diisocyanate, 2,4-tolylene diisocyanate (TDI), 2,6-tolylene diisocyanate, 4,4'-diphenylmethane diisocyanate (MDI), 2,4-diphenylmethane diisocyanate, 4,4'-diisocyanatobiphenyl, 3,3'-dimethyl-4,4'-diisocyanatobiphenyl, 3,3 '-dimethyl-4,4'-diisocyanatodiphenylmethane, 1,5-naphthylene diisocyanate, 4,4',4"-triphenylmethane triisocyanate, m- isocyanatophenylsulfonyl isocyanate, and p- isocyanatophenylsulfonyl isocyanate, the aliphatic polyisocyanate may include ethylene diisocyanate, tetramethylene diisocyanate, hexamethylene diisocyanate (HDI), dodecamethylene diisocyanate, 1,6,11-undecane triisocyanate, 2,2,4-trimethylhexamethylene diisocyanate, lysine diisocyanate, 2,6-diisocyanatomethyl caproate, bis(2-isocyanatoethyl)fumarate, bis(2-isocyanatoethyl) carbonate, and 2-isocyanatoethyl-2,6-diisocyanatohexanoate, the alicyclic polyisocyanate may include isophorone diisocyanate (IPDI), 4,4'-dicyclohexylmethane diisocyanate (hydrogenated MDI), cyclohexylene diisocyanate, methylcyclohexylene diisocyanate (hydrogenated TDI), bis(2-isocyanatoethyl)-4-dicyclohexene-1,2-dicarboxylate, 2,5-norbornane diisocyanate, and 2,6-norbornane diisocyanate, but they are not particularly limited thereto.

The polyol-based compound is not particularly limited as long as it is capable of forming flexible polyurethane foam having high flexibility, and specifically, may include polyester polyol, polyether polyol, and a mixture thereof. As a non-limiting example, the polyester polyol may be polyethylene adipate, polybutylene adipate, poly (1,6-hexadipate), polydiethylene adipate, or poly (e-caprolactone), and as a non-limiting example, the polyether polyol may be polyethylene glycol, polydiethylene glycol, polytetramethylene glycol, and polyethylene propylene glycol, but the present invention is not limited thereto. The polyether polyol having a flexible structure may be preferable in terms of further improving flexibility of the foam. In this case, the catalyst is not particularly limited as long as it is commonly used in the art, but may include an amine-based catalyst, and as a non-limiting example, dimethylcyclohexylamine (DMCHM), tetramethylenediamine (TMHDA), pentamethylene Diethylenediamine (PMEDETA), or tetraethylenediamine (TEDA) may be used. A molecular weight of the polyol is not particularly limited as long as it is capable of forming flexible polyurethane, and for example, the molecular weight of the polyol may be a compound having a number average molecular weight of in the range of 500 to 20,000 g/mol, more preferably in the range of 800 to 10,000 g/mol, even more preferably in the range of 1,000 to 5,000 g/mol. A soft segment property of the polyurethane-based foam may be improved in the above-described ranges to improve flexibility and elasticity, and possibility of occurrence of defects such as cracks and the like occurring during the curing and foaming may be minimized.

Further, the second form may form the polymer from an addition reaction between a urethane-based prepolymer containing an ethylenic unsaturated group and the crosslinking agent. The urethane-based prepolymer may have various structures varied according to kinds of an isocyanate group-containing compound and a polyol-based compound, but the urethane-based prepolymer may be an ethylenic unsaturated group, more specifically, a urethane prepolymer containing a vinyl group. As a specific example, 2 to 20 vinyl groups may be contained in a single polyurethane chain, but are not limited thereto, and as the molecular weight of the polyurethane increases, the vinyl group may proportionally increase to more than 20 groups, and polyurethane having a low molecular weight may include 2 to 4 vinyl groups. In this case, the crosslinking agent may be a vulcanizing agent, and the vulcanizing agent is not limited as long as it is commonly used in the art, and as a non-limiting example, sulfur or organic peroxide may be used.

The silicone-based foam may be made from a silicone-based foam precursor, and in this case, the silicone-based foam precursor may include aliphatic polysiloxane and an aromatic polysiloxane which has two or more hydroxy groups, or a condensation type silicone-based prepolymer such as polysiloxane containing an aliphatic group and an aromatic group in one repeat unit or siloxane repeating units independently having the aliphatic group and the aromatic group. In this case, 2 to 20 hydroxyl groups may be included in a single polysiloxane chain, but are not limited thereto, and as a molecular weight of the polysiloxane increases, the hydroxy group may proportionally increase to more than 20, and polysiloxane having a low molecular weight may preferably include 2 to 4 hydroxyl groups. As a specific non-limiting example, the aliphatic polysiloxane may be selected from the group consisting of polydimethylsiloxane, polydiethylsiloxane, polymethylethylsiloxane, polydimethylsiloxane-co-diethylsiloxane, and polydimethylsiloxane-co-ethylmethylsiloxane which each contain two or more hydroxyl groups, and the aromatic polysalic acid may be selected from the group consisting of polydiphenylsiloxane, polymethylphenylsiloxane, polyethylphenylsiloxane, and poly(dimethylsiloxane-co-diphenylsiloxane) which each contain two or more hydroxy groups. The polysiloxane containing a siloxane repeat unit containing both the aliphatic group and the aromatic group in one repeat unit or independently containing the aliphatic group and the aromatic group may include both a repeat unit of the exemplified aliphatic siloxane and a repeat unit of the aromatic siloxane or may refer to a form in which the exemplified aliphatic substituent and the exemplified aromatic substituent are bonded to a silicone element located in one repeat unit, but the polysiloxane is not limited thereto.

Further, the silicone-based foam precursor may include an addition-type silicone prepolymer such as a polysiloxane containing an aliphatic polysiloxane and an aromatic polysiloxane which each contain two or more vinyl groups, or a siloxane repeat unit containing both the aliphatic group and the aromatic group in one repeat unit or independently containing the aliphatic group and the aromatic group. As a specific example, 2 to 20 vinyl groups may be included in a single polysiloxane chain, but are not limited thereto, and as a molecular weight of the polysiloxane increases, the vinyl group may proportionally increase to more than 20, and polysiloxane having a low molecular weight may include 2 to 4 hydroxyl groups. As a specific non-limiting example, the aliphatic polysiloxane may be selected from the group consisting of polydimethylsiloxane, polydiethylsiloxane, polymethylethylsiloxane, polydimethylsiloxane-co-diethylsiloxane, and polydimethylsiloxane-co-ethylmethylsiloxane which each contain two or more vinyl groups, and the aromatic polysalic acid may be selected from the group consisting of polydiphenylsiloxane, polymethylphenylsiloxane, polyethylphenylsiloxane, and poly(dimethylsiloxane-co-diphenylsiloxane) which each contain two or more vinyl groups. The polysiloxane containing a siloxane repeat unit containing both the aliphatic group and the aromatic group in one repeat unit or independently containing the aliphatic group and the aromatic group may include both a repeat unit of the exemplified aliphatic siloxane and a repeat unit of the aromatic siloxane or may refer to a form in which the exemplified aliphatic substituent and the exemplified aromatic substituent are bonded to a silicone element located in one repeat unit, but the polysiloxane is not limited thereto. At this point, the condensation type silicone prepolymer may undergo crosslinking and curing by hydrolysis and condensation reaction in the presence of water, and the addition type silicone prepolymer may undergo crosslinking and curing by an addition reaction between the unsaturated group of the silicone-based prepolymer and the crosslinking agent in the presence of the catalyst.

In addition to the aforementioned, the silicone-based foam precursor may further include a crosslinking agent, a catalyst, or a mixture thereof, and the crosslinking agent, the catalyst, or the mixture may be used without particular limitation as long as it is commonly used in the art.

For example, when the silicone-based foam precursor contains a condensation type silicone-based prepolymer, the crosslinking agent may be a siloxane-based curing agent containing a Si-O bond, an organosilazane curing agent containing a Si-N bond, or the like, and as a non-limiting example, the crosslinking agent may be $(CH_3)Si(X)_3$ or $Si(OR)_4$. In this case, X may be methoxy, acetoxy, oxime, and an amine group, and R may have a lower alkyl group and, as a non-limiting example, R may be methyl, ethyl, or a propyl group. The catalyst is not limited as long as it is commonly used in the art, and as a non-limiting example, an organic tin compound, an organic titanium compound, or an amine-based compound may be used.

Alternatively, when the silicone-based foam precursor contains the addition type silicone prepolymer, the crosslinking agent may be used without limitation as long as it is any siloxane-based compound containing a Si-H bond, and as a non-limiting example, the crosslinking agent may be an aliphatic or aromatic polysiloxane containing a $-(R_aH\text{-}SiO)$-group. $R_a$ may be the aliphatic group or the aromatic group, the aliphatic group may be a methyl group, an ethyl group, or a propyl group, the aromatic group may be a phenyl group or a naphthyl group, and the substituent may be substituted with another substituent or may be unsubstituted within a range not affecting the crosslinking reaction, but the aforementioned is only one example and the number of carbon atoms and a kind of substituent are not limited. As a non-limiting example, there may be polymethylhydrogensiloxane $[(CH_3)_3SiO(CH_3HSiO)_xSi(CH_3)_3]$, polydimethylsiloxane $[(CH_3)_2HSiO((CH_3)_2SiO)_xSi(CH_3)_2H]$, polyphenylhydrogensiloxane $[(CH_3)_3SiO(PhHSiO)_xSi(CH_3)_3]$, or polydiphenylsiloxane $[(CH_3)_2HSiO((Ph)_2SiO)_xSi(CH_3)_2H]$, and in this case, a content of Si-H is preferably controlled according to the number of vinyl groups contained in the addition type silicone prepolymer, and for example, x may be in a range of 1 or more, more preferably in a range of 2 to 10, but is not limited thereto.

In this case, the catalyst may selectively be added to accelerate the reaction and is not limited as long as it is commonly used in the art, and as a non-limiting specific example, a platinum compound or the like may be used.

The polyolefin-based foam may be manufactured from a polyolefin-based foam precursor, and the polyolefin-based foam precursor may contain a polyolefin-based prepolymer. The polyolefin-based prepolymer may be crosslinked and cured by the crosslinking agent to form a polymer, and as a non-limiting example, the polymer may be poly(ethylene-co-alpha-olefin), ethylene propylene diene monomer rubber (EPDM rubber), polyisoprene, or polybutadiene, but is not limited thereto. In this case, the crosslinking agent may be a vulcanizing agent, and the vulcanizing agent is not limited as long as it is commonly used in the art, and as a non-limiting example, sulfur or organic peroxide may be used.

The polyurethane-based foam may be used as the foam to significantly lower the thermal conductivity. In this case, there is an advantage in that adhesive strength between a foam and an electrode and between the foam and a thermoelectric material is high and thus a glass frit, which is necessarily added to the electrode or the thermoelectric material so as to improve adhesive strength, can be excluded. As described above, since the glass frit having low electrical conductivity may be excluded from the electrode or the thermoelectric material, the efficiency of the thermoelectric power generation of the flexible thermoelectric element can further be improved, and also since the electrode or the thermoelectric material can be formed without using a paste, a manufacturing process of the flexible thermoelectric element can be significantly simplified.

That is, when the polyurethane-based foam is used as the filling material, adhesion between the filling material and the electrode and between the electrode and the thermoelectric material is significantly increased, so that desired adhesion may be secured without using the glass frit. However, the present invention does not completely exclude the glass frit, and even if the glass frit is excluded, sufficient adhesive strength may be secured, but when higher adhesive strength is required, the glass frit may be included in the electrode or the thermoelectric material.

More preferably, the polyurethane-based foam according to one embodiment of the present invention may be a polyisocyanate-based compound and be manufactured from the urethane-based foam precursor containing the aromatic polyisocyanate. Accordingly, the filling material may have significantly high thermal conductivity of 0.05 W/m.K or less while securing high adhesive strength, high flexibility, and high mechanical stability. Specifically, the aromatic polyisocyanate may be 4,4'-diphenylmethane diisocyanate (MDI) or 2,4-diphenylmethane diisocyanate.

Further, in each of the foam precursors according to one embodiment of the present invention, contents of the prepolymer, the crosslinking agent, and the catalyst may be selected in consideration to a degree of curing of a pre-designed foam. Specifically, the content of the crosslinking agent may be in the range of 1 to 100 parts by weight based on 100 parts by weight of the prepolymer, preferably in the range of 3 to 50 parts by weight, and more preferably in the range of 5 to 20 parts by weight. The content of the catalyst may be in the range of 0.001 to 5 parts by weight based on 100 parts by weight of the prepolymer, preferably in the range of 0.1 to 1 parts by weight. In the above-described ranges, a foam having high flexibility, high adhesive strength, and low thermal conductivity may be effectively formed such that the element may be implemented to have high stability even with frequent physical changes and thermal diffusion may be effectively prevented to significantly improve thermoelectric efficiency.

Further, in each of the foam precursors according to one embodiment of the present invention, it is preferable to control the type and content of the foaming agent according to a type of the precursor and required physical properties of the foam, but the foaming agent may not particularly be limited and may be used as long as it is conventionally used in the art. For example, when a material which will be foamed is the aforementioned prepolymer, the foaming agent may be selected from a hydrocarbon-type compound, a nitroso-type compound, an azo-type compound, an azide-type compound, an inorganic-based foaming agent, and water ($H_2O$). As an example of the foaming agent, the hydrocarbon-type compound may be n-butane, iso-butane, n-pentane, iso-pentane, or cyclopentane, the nitroso-type compound may be N,N'-dimethyl-N,N'-dinitrozoterephthalate imide or dinitroso penta methylenetetramine, the azo-type compound may be azodicarbonamide, diazoaminoazobenzene, or azobis (isobutyronitrile), the azide-type compound may be p,p'-oxy-bis (benzenesulfonyl salicylhydrazide), toluenesulfonyl semicarbazide, p,p'-oxy-bis (benzenesulfonylhydrazide), p,p'-diphenylbis (sulfonyl hydrazide), toluenesulfonylhydrazide, benzenesulfonyl hydrazide, or m-benzene-bis (sulfonium hydrazide), the inorganic foaming agent may be sodium hydrogen carbonate, ammonium carbonate, nitric acid ammonium, or ammonium chloride, but the present invention is not limited thereto.

As an example, when a polyurethane-based foam is formed as the filling material, the foaming agent may be water, and thus an isocyanate group (-NCO) reacts with water and a carbon dioxide gas may be discharged to form the polyurethane-based foam having significantly low thermal conductivity.

Also, the foaming agent may perform a function of curing the prepolymer by application of external energy such as heat or light and simultaneously perform a function of foaming. For example, when the prepolymer contains the vinyl group which may be cured by a radical, the foaming agent may contain a thiol group or a radical generating substituent, which may react with the vinyl group to induce curing, and a gas may be generated due to reassembly, deformation, or decomposition of molecules of the foaming agent according to the application of the external energy. As a specific example, the azo-type compound is heated and decomposed to generate a radical, and at the same time, the nitrogen gas is generated such that the prepolymer is simultaneously foamed and cured to form the foam.

The foaming agent according to one embodiment is preferably added in an amount with which the prepolymer may be sufficiently foamed to become the foam, and as a specific example, the foaming agent may be used in the range of 0.1 to 20 parts by weight based on 100 parts by weight of the prepolymer, preferably in the range of 1 to 10 parts by weight. When the content of the foaming agent is too small, the foam may not be sufficiently formed, and when the amount of the foaming agent is too large, the foaming may excessively occur, and thus mechanical strength may be weakened, or the thermoelectric element may be damaged.

Further, the foam precursor may also contain one or more selected from among a plasticizer, a foam stabilizer, a filler, and a pigment according to target properties of a foam which will be formed.

In one embodiment of the present invention, surface-modified aerosol silica, a surface-modified quartz powder, a surface-modified calcium carbonate powder, or a surface-modified diatomaceous earth powder may be used as the filler. As a specific non-limiting example, the filler may be surface-modified with the vinyl group, the Si-H group, or the hydroxyl group through a coupling agent. Through such a functional group, the filler may stably be bonded to a foam network, and fracture toughness of the foam may be improved. A content of the filler is preferably controlled within a range without degrading flexibility and adhesive strength of the foam, and as a specific example, the filler may be added in the range of 0.01 to 5 parts by weight based on 100 parts by weight of the prepolymer but is not limited thereto.

Accordingly, the foam may have porosity as high as possible in terms of thermal conductivity degradation, but the foam may be controlled to have mechanical strength of a certain level or more. As a specific example, the porosity (apparent porosity) of the foam may be in the range of 50 to 98% by volume, preferably in the range of 70 to 90% by volume. In the above-described ranges, thermal diffusion may be effectively prevented to significantly increase the thermoelectric efficiency, and sufficient mechanical strength may be provided to improve the lifetime and reliability of the thermoelectric element.

In one embodiment of the present invention, the foam is preferably kept flexible in a wide temperature range in consideration of an environment in which the thermoelectric element operates, and thus it is preferable to control a glass transition temperature $T_g$ of the foam. For example, the glass transition temperature of the foam may be in the range of -150 to 0 °C, and preferably, a maximum temperature of the glass transition temperature may be -20 °C or less in terms of maintaining flexibility and adhesive strength with the electrode.

Further, in one embodiment of the present invention, the foam preferably maintains flexibility and mechanical properties even under an environment where high physical deformation is applied, and thus it is preferable to control a shore A and tensile strength of the foam. As a specific example, hardness of the foam may be in the range of 10 to 40, preferably in the range of 20 to 35 so as to have higher flexibility. Further, as a specific example, tensile strength may be in the range of 30 to 300 $kg/cm^2$, preferably in the range of 40 to 90 $kg/cm^2$.

Also, in one embodiment of the present invention, the foam may be formed by filling in a void formed by the thermoelectric material column array with a foam precursor and curing and foaming the foam precursor material. The void may cause a capillary phenomenon since the void is a minute space, and thus the foam precursor may uniformly fill in the void using a liquid material in a simplified manner. That is, as a specific non-limiting example, the foam precursor may be a liquid material, and specifically, the foam precursor may be the polymer or the prepolymer in a liquid phase or a solution phase dissolved in a solvent. Such a liquid foam precursor may uniformly and effectively fill in the void due to the capillary phenomenon and may be entirely well adhered to the electrode and the thermoelectric material after curing and foaming to better improve mechanical and physical properties of the thermoelectric element. Alternatively, when the polymer or the prepolymer is in a liquid phase at a process temperature (e.g., room temperature), the void of the thermoelectric material column array may be filled with the capillary phenomenon without using a solvent, and thus a solvent volatilization process may not be required. That is, when the polymer or the prepolymer is in a liquid phase, drying may not be required, and the foam may be formed by only curing and foaming. Specifically, drying may be omitted such that productivity and quality may be improved when a large-area flexible thermoelectric element is manufactured.

In order to more effectively fill the void formed by the thermoelectric material column array with the foam precursor, a viscosity of the foam precursor may be appropriately controlled. As a specific example, the foam precursor may have a viscosity of 1,000 cps or less, preferably in the range of 100 to 1,000 cps, more preferably 100 to 600 cps, and even more preferably 200 to 500 cps. At this point, the foam precursor may be controlled in viscosity as necessary by a conventional viscosity adjusting agent so as to have a desired viscosity. The viscosity of the foam precursor may be a viscosity such that, even when the capillary phenomenon is reduced due to a physical size or a shape of the thermoelectric element, the foam precursor may easily fill in the void formed by the thermoelectric material column array.

Further, in one embodiment of the present invention, the foam precursor may have an appropriate contact angle so as to fill in the void of the thermoelectric material column array by a more effective capillary phenomenon. In order to improve the adhesive strength between the filling material and the electrode, it is preferable that the foam precursor forming the filling material by hardening is well wet with the electrode. Since the electrode has a configuration in which an area is in wide contact with the filling material rather than the thermoelectric material, a contact angle between the electrode and the foam precursor may be more important. In order to fill the void of the thermoelectric material column array with the foam precursor, it is preferable that the foam precursor is well wet with the thermoelectric material rather than the electrode, when the foam precursor is not well wet, there may occur a problem in that the void of the thermoelectric material column array is not fully filled with the foam precursor. The contact angle between the electrode and the foam precursor may be a contact angle which is determined by interfacial tension balance due to interfacial energy at an electrode-droplet interface, an electrode-gas interface, and the droplet-gas interface when a foam precursor droplet is dropped onto an upper portion of the electrode in the form of a flat plate (or a film). As a specific example, the contact angle between the foam precursor and the electrode may be less than 90 degrees, preferably in the range of 0 to 60 degrees.

Next, the electrode according to one embodiment of the present invention is not particularly limited as long as it is commonly used in the art, and the electrode may be formed using a conductive metal film or an electrode paste, and a concrete manufacturing method thereof will be described in detail in a method of manufacturing the thermoelectric material, which will be described below.

Further, in one embodiment of the present invention, the P-type thermoelectric material and the N-type thermoelectric material of the thermoelectric material column array may be formed by a conventional method and may be formed using a single crystal or a polycrystalline bulk thermoelectric material, and a concrete formation method thereof will be described in detail in a method of manufacturing a flexible thermoelectric material, which will be described below.

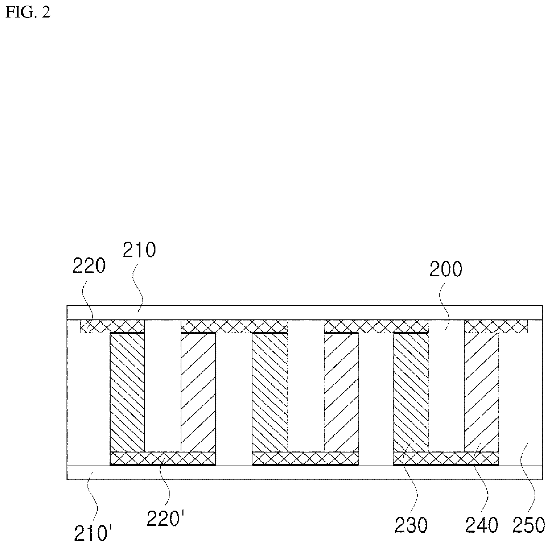

More specifically, as shown in FIG. 2, a flexible thermoelectric element 200 according to one embodiment of the present invention includes one or more thermoelectric material column arrays disposed and spaced apart from each other and having at least one N-type thermoelectric material 240 and a P-type thermoelectric material 230, a first electrode 220 and a second electrode 220' configured to electrically connect thermoelectric materials of the one or more thermoelectric material column arrays, and a foam 250 configured to fill in at least one void of the one or more thermoelectric material column arrays.

According to one embodiment of the present invention, the thermoelectric material column arrays may thermally be connected in parallel and electrically be connected in series and/or in parallel through the electrodes and the thermoelectric material column arrays in the flexible thermoelectric element.

As a specific example, the flexible thermoelectric element 200 may thermally be connected in parallel and electrically be connected in series through the first electrode 220, the second electrode 220', and the thermoelectric material column arrays as shown in FIG. 2. Notably, as a specific example, one end of the N-type thermoelectric material 240 may be connected to one end of one surface of the first electrode 220, and one end of one surface of the second electrode 220' may be connected to the other end of the N-type thermoelectric material 240. Continuously, one end of the P-type thermoelectric material 230 may be connected to the other end of one surface of the first electrode 220, the other end of the P-type thermoelectric material 230 may be connected to one end of one surface of another first electrode 220 spaced apart from the first electrode 220, and the flexible thermoelectric element 200 may be configured by having a repeat unit as the aforementioned connection configuration.

In one embodiment of the present invention, a size and a shape of each of the N-type thermoelectric material and the P-type thermoelectric material may be appropriately designed in consideration of the use of the thermoelectric element so long as flexibility of the flexible thermoelectric element is not degraded. As a specific example, the N-type and P-type thermoelectric materials may have the same shape and size or different shapes and sizes from each other. More specifically, the N-type and P-type thermoelectric materials may independently be in the form of a plate or a column, and each of the N-type and P-type thermoelectric materials may have a cross section in a shape with a curved line such as a circle or an ellipse or an angular shape in a thickness or length direction. In order not to degrade the flexibility of the flexible thermoelectric element, a thickness of the N-type or P-type thermoelectric material may have a thickness in the range of several tens of nanometers order to tens of millimeters order. Further, a cross-sectional area of an N-type or P-type thermoelectric column may have an area in the range of hundreds of square nanometers order to several square centimeters order. As a practical example, the N-type or P-type thermoelectric material may have a thickness in the range of 100 nm to 5 cm, and the cross-sectional area of the thermoelectric material column may be in the range of 0.1 $\mu m^2$ to 10 $cm^2$, but the present invention is not limited by a physical shape or size of the thermoelectric material. As described above, since the thermoelectric material may be manufactured with a thickness in the nanometer order, the flexible thermoelectric element according to one embodiment of the present invention may also be manufactured with the thickness in the nanometer order, and miniaturization and integration of the flexible thermoelectric element are possible. Further, since the flexible thermoelectric element may be manufactured such that the cross-sectional area of the thermoelectric material column is formed in the order of $\mu m^2$ or less, it is possible to integrate a very large number of thermoelectric material columns within a given overall element area, such that it is advantageous for raising an overall output voltage.

A method of manufacturing a flexible thermoelectric element according to the present invention will be described below. At this point, a foam precursor used in a foaming operation is identical to the described above, and thus a repetitive description thereof will be omitted.

A method (I) of manufacturing a flexible thermoelectric element according to one embodiment of the present invention may include a) forming a first structure in which a first sacrificial substrate, a first contact thermal conduction layer, a first electrode, and a P-type thermoelectric material formed at a predetermined region on the first electrode are sequentially stacked, and a second structure in which a second sacrificial substrate, a second contact thermal conduction layer, a second electrode, and an N-type thermoelectric material formed at a predetermined region on the second electrode are sequentially stacked, b) manufacturing a substrate having thermoelectric material column arrays formed by physically connecting the first structure and the second structure, c) forming a foam in a void between the thermoelectric material column arrays of the substrate, and d) removing the first sacrificial substrate and the second sacrificial substrate.

First, the forming of the first structure according to the operation a) includes a-1) forming the first contact thermal conduction layer on the first sacrificial substrate, a-2) forming the first electrode on the first contact thermal conduction layer, and a-3) forming the P-type thermoelectric material at a predetermined region on the first electrode. The forming of the second structure is performed in the same manner as the forming of the first structure except for forming the N-type thermoelectric material at a predetermined region on the second electrode, and thus a repetitive description will be omitted.

In the operation a-1) according to one embodiment, the first sacrificial substrate serves as a support for maintaining a shape of the flexible thermoelectric element until the manufacturing of the flexible thermoelectric element is completed, and the first sacrificial substrate may further include a sacrificial film according to a characteristic of adhesive strength between the first sacrificial substrate and the first contact thermal conduction layer. That is, when the adhesive strength between the first sacrificial substrate and the first contact thermal conduction layer is low, the sacrificial film is not required, and when the adhesive strength therebetween is high, the first sacrificial substrate may further include the sacrificial film. Specifically, the sacrificial film may be used without particular limitation when the sacrificial film is a metal thin film or a polymer layer which has poor adhesive strength to the first sacrificial substrate, and as a specific example, the metal thin film may be a nickel thin film and the polymer layer may be formed by applying a polymer adhesive on the substrate, and as a specific example, the polymer adhesive may be a mixture or compound composed of one or more selected from a glue, a starch, acetyl cellulose, polyvinyl acetate, epoxy, urethane, chloroprene rubber, nitrile rubber, a phenol resin, a silicate-based resin, an alumina cement, a urea resin, a melamine resin, an acrylic resin, a polyester resin, a vinyl/phenol resin, and an epoxy/phenolic resin. In this case, any method known in the art may be used as a method for forming a sacrificial film as long as it is capable of forming a metal thin film on a substrate. As a specific example, the sacrificial film may be formed by spin coating, a screen printing technique, sputtering, thermal evaporation, chemical vapor deposition, electrodeposition, or spray coating.

Any type of a material may be used as the first sacrificial substrate without limitation as long as it has poor adhesive strength to the first contact thermal conduction layer or the sacrificial film, and a material, a shape, a size, and the like of a substrate are not limited. As a specific example, the first sacrificial substrate may employ any one selected from among silicone, silicone oxide, sapphire, alumina, mica, germanium, silicone carbide, gold, silver, and a polymer.

The first contact thermal conduction layer is used to form a thermal conduction layer capable of minimizing a heat loss of the flexible thermoelectric element, and the first contact thermal conduction layer may preferably be formed of a material having high thermal conductivity, and as a specific example, aluminum nitride (A1N), silicone nitride (Si$_3$N$_4$), alumina (Al$_2$O$_3$), or the like may be used but the present invention is not limited thereto. Any known method may be used as a method of forming a first contact thermal conductor as long as it is capable of forming a first contact thermal conductor thin film on the substrate. As a specific example, the sacrificial film may be formed by spin coating, a screen printing technique, sputtering, thermal evaporation, chemical vapor deposition, electrodeposition, or spray coating.

The operation a-2) according to one embodiment is an operation of forming the first electrode, and any method may be used as long as it is capable of forming the first electrode according to a designed pattern, and for example, the first electrode may be formed using a conductive metal film or a paste for an electrode. When an electrode paste is used to form an electrode, the electrode may be formed by screen printing, sputtering, evaporation, chemical vapor deposition, pattern transfer, electrodeposition, or the like.

As an example of the electrode, when the conductive metal film is used as the electrode, the conductive metal film may be selected in consideration of a type, thermal conductivity, electrical conductivity, a thickness, and the like of a designed electrode. For example, the conductive metal film may be a transition metal film of Group 3 to Group 12, and as a specific example, a transition metal may be one or a mixture of two or more selected from nickel (Ni), copper (Cu), platinum (Pt), ruthenium (Ru), rhodium (Rh), gold (Au), tungsten (W), cobalt (Co), palladium (Pd), titanium (Ti), tantalum (Ta), iron (Fe), molybdenum (Mo), hafnium (Hf), iridium (Ir), and silver (Ag), and it is preferable to use a copper (Cu) film in terms of high electrical conductivity, adhesive strength to a filling material, and a low cost.

Further, when the electrode is formed using the electrode paste, the electrode paste may include a first conductive material, and specifically, may contain the first conductive material, a first solvent, and a first binder. For example, a composition and a content of each component of the electrode paste may be controlled in consideration of a type, thermal conductivity, electrical conductivity, thickness, and the like of a designed electrode. As a specific example, the electrode paste may include 10 to 90% of the first conductive material by weight, 5 to 50% of the first solvent by weight, and 2 to 10% of the first binder by weight among a total weight.

More specifically, a type of the first conductive material according to a non-limiting example is not particularly limited as long as it is a material having high thermal conductivity and electrical conductivity, and for example, a metal material or a carbon nanotube and a carbon nanowire that possess high electric conductivity may be used. It is preferable to use a metal material which is high in thermal conductivity and electric conduction characteristics and is high in binding strength to the filling material to improve physical strength of the thermoelectric element. For example, the metal material may be a transition metal film of Group 3 to Group 12, and specifically, a transition metal may be one or more selected from Ni, Cu, Pt, Ru, Rh, Au, W, Co, Pd, Ti, Ta, Fe, Mo, Hf, Ir, and Ag, and it is preferable to use a Cu film in terms of high electrical conductivity, binding strength to the filling material, and a low cost. The first solvent is used to control fluidity of the paste for an electrode and is not particularly limited as long as it is capable of dissolving the first binder, and as a specific example, an alcohol-based solvent, a ketone-based solvent, or a mixed solvent thereof may be used. The first binder is used to control printing resolution, and as a specific example, a resin-based material may be used.

Further, in one embodiment of the present invention, when high adhesive strength between the electrode and the filling material is required, a glass frit may further be added to the paste for an electrode in order to manufacture the electrode.

In one embodiment of the present invention, a relative content of the glass frit with respect to the first conductive material may be controlled in consideration of improvement in adhesive strength and degradation in electrical conductivity due to the glass frit. As a specific example, the electrode may contain the glass frit in the range of 0.1 to 20 parts by weight based on 100 parts of the first conductive material by weight. At this point, in order to improve the flexibility of the thermoelectric element, it is preferable to implement the electrode as thinly as possible. However, as the thickness of the electrode becomes thinner, degradation in electrical conductivity may occur due to the glass frit. Accordingly, the relative content of the glass frit with respect to the first conductive material is preferably within a minimum content range in which an improving effect of the adhesive strength may be exhibited. In this regard, the electrode may contain the glass frit in the range of 0.5 to 10 parts by weight, specifically in the range of 1 to 5 parts by weight based on 100 parts of the first conductive material by weight.

However, as described above, since the thermoelectric element according to the present invention may have high adhesive strength between the electrode and the filling material when using the foam as the filling material, it is not necessary to add the glass frit, and thus the electrode may be manufactured through a very simplified process using the conductive metal film and the glass frit may not be added to the electrode, such that thermal conductivity and the electrical conductivity of the electrode are improved and there is an advantage in that thermoelectric efficiency of the thermoelectric element may be improved.

The operation a-3) according to one embodiment is an operation of forming the thermoelectric material, and specifically, an operation of forming the P-type thermoelectric material at a predetermined region on the patterned first electrode. Any method may be used as the operation a-3) as long as it is capable of forming the P-type thermoelectric material at a predetermined region on the first electrode as designed, and for example, the P-type thermoelectric material may be formed using a single crystal, a polycrystalline bulk material, or a paste for a thermoelectric material. Specifically, the single crystal may be used as the thermoelectric material because the flexible thermoelectric element according to one embodiment of the present invention does not need to provide a flexible mesh through improvement in adhesive strength between the electrode and the filling material.

However, as shown in FIG. 2, when the first structure and the second structure are connected to each other, the P-type thermoelectric material formed at the first electrode and the N-type thermoelectric material formed at the second electrode should be formed and spaced apart from each other so as to be electrically connected by the electrode as designed in advance.

As a specific example, when the P-type thermoelectric material is formed of a bulk material, an antimony-tellurium-based compound ($Sb_xTe_{1-x}$) or a bismuth-antimony-tellurium-based compound ($Bi_ySb_{2-y}Te_3$) (x is $0 \leq x \leq 1$ and y is $0 \leq y \leq 2$) may be formed in a designed shape through a process such as cutting or the like to have a suitable shape, and then the P-type thermoelectric material may be adhered to the upper portion of the first electrode in a designed pattern using a conductive adhesive. In this case, the conductive adhesive may be a silver paste containing silver, and as a specific example, a silver (Ag) paste, a tin-silver (Sn-Ag) paste, a tin-silver-copper (Sn-Ag-Cu) paste, or a tin-antimony (Sn-Sb) paste may be used, but the present invention is not limited thereto.

Also, when the P-type thermoelectric material is formed in a thick film form using a thermoelectric material paste, the P-type thermoelectric material may be formed through screen printing, and specifically, the P-type thermoelectric material may be applied on the upper portion of the first electrode as a designed pattern and then may undergo heat treatment to form the thermoelectric material.

The P-type thermoelectric material paste may include a second conductive material, and more specifically, may contain the second conductive material, a second solvent, and a second binder. For example, a composition and a content of each component of the P-type thermoelectric material paste may be controlled in consideration of a type, thermal conductivity, electrical conductivity, thickness, and the like of a designed thermoelectric material.

Preferably, the second conductive material uses an antimony-tellurium-based ($Sb_xTe_{1-x}$) compound or a bismuth-antimony-tellurium-based ($Bi_ySb_{2-y}Te_3$) compound (x is $0 \leq x \leq 1$ and y is $0 \leq y \leq 2$). The second solvent is used to control fluidity of the P-type thermoelectric material paste and is not particularly limited as long as it is capable of dissolving the second binder. As a specific example, an alcohol-based solvent, a ketone-based solvent, or a mixed solvent thereof may be used. The second binder is used to control printing resolution, and as a specific example, a resin-based material may be used.

It may be preferable that contents of constituent components of the P-type thermoelectric material paste are controlled so as to allow the thermoelectric material column array to have a thermoelectric performance index ZT of 0.1 $K^{-1}$ or more. As a specific example, the P-type thermoelectric material paste may include 10 to 90% of the second conductive material by weight, 5 to 50% of the second solvent by weight, and 2 to 10% of the second binder by weight based on a total weight.

In the operation a-3) according to one embodiment, the P-type thermoelectric material paste may be applied on the upper portion of the first electrode as a designed pattern and then may undergo heat treatment to form the P-type thermoelectric material. A heat treatment may be performed through a method which is commonly used in the art, and as a specific example, annealing may be performed at a temperature in the range of 300 to 1000 °C for 30 to 200 minutes to form the P-type thermoelectric material, and preferably, the annealing may be performed at a temperature in the range of 400 to 600 °C for 60 to 120 minutes.

Meanwhile, the second structure may be formed such that the second electrode is formed through the same method as in the first structure and then the N-type thermoelectric material may be formed at a predetermined region on the second electrode. In this case, the N type thermoelectric material may use a bulk material, or an N type thermoelectric material paste.

As a specific example, when the N-type thermoelectric material is formed of a bulk material, a bismuth-tellurium-based compound ($Bi_xTe_{1-x}$) or a bismuth-tellurium-selenium-based compound ($Bi_2Te_{3-y}Te_3$) (x is $0 \leq x \leq 1$ and y is $0 \leq y \leq 2$) may be formed in a designed shape through a process such as cutting or the like to have a suitable shape, and then the N-type thermoelectric material may be adhered to the upper portion of the second electrode in a designed pattern using a conductive adhesive. In this case, the conductive adhesive may be a silver paste containing silver, and as a specific example, an Ag paste, a Sn-Ag paste, a Sn-Ag-Cu paste, or a Sn-Sb paste may be used, but the present invention is not limited thereto.

Also, when the N-type thermoelectric material is formed in a thick film form using a thermoelectric material paste, the N-type thermoelectric material may be formed through screen printing, and specifically, the N-type thermoelectric material may be applied on the upper portion of the second electrode as a designed pattern and then may undergo heat treatment to form the thermoelectric material. The N-type thermoelectric material paste may be the same as the P-type thermoelectric material paste except for the second conductive material. Specifically, the N-type thermoelectric material paste may preferably use a bismuth-tellurium-based ($Bi_xTe_{1-x}$) compound or a bismuth-tellonium-selenium ($Bi_2Te_{3-y}Se_y$) compound (x is $0 \leq x \leq 1$ and y is $0 \leq y \leq 2$) as the second conductive material.

In this case, in the P type or the N type thermoelectric material, when a thermoelectric material contains tellurium (Te), in order to prevent evaporation of tellurium (Te) during heat treatment at a high temperature, the heat treatment may be performed by inserting a tellurium (Te) powder into a heat treatment oven or a heat treatment furnace.

Next, the operation b) manufacturing the substrate having the thermoelectric material column array formed by physically connecting the first structure and the second structure may be performed. As described above, the first structure and the second structure may be connected to separate the thermoelectric materials from each other, and as shown in FIG. 2, the first and second structures may be connected to alternately dispose the P-type thermoelectric material and the N-type thermoelectric material. For example, the above-described connection may be performed through bonding, and bonding is not particularly limited as long as it is capable of bonding the electrode and the thermoelectric material, and for example, bonding may be performed using a conductive adhesive. For example, the conductive adhesive may be a silver paste containing silver, and as a specific example, a silver (Ag) paste, a tin-silver (Sn-Ag) paste, a tin-silver-copper (Sn-Ag-Cu) paste, or a tin-antimony (Sn-Sb) paste may be used, but the present invention is not limited thereto.

Next, the operation c) of forming the foam in the void between the thermoelectric material column arrays of the substrate may be performed. That is, through the operation c), the thermoelectric material may physically be supported, and mechanical properties of the thermoelectric element may be secured. Specifically, the operation c) may include c-1) filling the foam precursor in the void between the thermoelectric material column arrays of the substrate, and c-2) forming the foam by curing and foaming the foam precursor. Further, it is preferable to remove the foam remaining in an unnecessary portion except for the void after the forming of the foam which is the filling material.

The operation c-1) according to one embodiment is not limited as long as it is capable of filling the foam precursor in a gap between the N-type thermoelectric material and the P-type thermoelectric material, and for example, a liquid phase foam precursor may fill in the substrate on which the electrode and the thermoelectric material column arrays are formed using a capillary phenomenon, or may fill in the substrate by dipping the substrate on which the electrode and the thermoelectric material column arrays are formed in a water tank filled with the liquid phase foam precursor.

The operation c-2) according to one embodiment is an operation of curing and foaming the foam precursor filling in the void formed by the thermoelectric material column arrays to form the foam, and at this point, the foam precursor may contain a polymer, a prepolymer, or a foaming agent, and when the polymer or the prepolymer is in a liquid phase, drying may be omitted but when the polymer or the prepolymer is in a solution phase dissolved in a solvent, drying may be further performed before the curing and foaming. Drying according to one embodiment may be performed at a temperature at which the solvent may sufficiently be blown for a predetermined period of time. As a specific example, when the prepolymer is a urethane-based prepolymer, a drying temperature may be in the range of room temperature to 150 °C, and a drying time may be in the range of 1 minute to 24 hours.

The curing and foaming in the operation c-2) may be varied according to a type and a content of the polymer, the prepolymer, or the foaming agent. In this case, the polymer, the prepolymer, or the foaming agent may be the same as described in the flexible thermoelectric element.

Next, the operation d) of removing the first sacrificial substrate and the second sacrificial substrate may be performed. In the operation d) according to one embodiment, when a sacrificial substrate on which a sacrificial film is not formed is used, the removing may be performed by peeling only the sacrificial substrate from the contact thermal conduction layer, and any method may be used without limitation as long as it is capable of peeling the sacrificial substrate from the contact thermal conduction layer, and for example, the sacrificial substrate may physically or chemically be peeled in air or water.

In the case of the sacrificial substrate having the sacrificial film formed thereon in an operation d) according to another embodiment, the removing of the sacrificial substrate may be performed by removing a substrate from the sacrificial substrate and then removing the sacrificial film. The removing method may be used without particular limitation as long as it is capable of peeling only the substrate from the sacrificial film, and for example, the substrate may physically or chemically be peeled in air or water. As a specific example, when a silicone oxide film substrate having a nickel film formed thereon is used as the sacrificial film, peeling occurs at an interface between the silicone oxide film substrate and the nickel film in the case that a pre-thermoelectric element having the filling material formed therein is immersed in a water bath for a predetermined period of time. The removing of the sacrificial film may be performed through etching, and the method of etching is not particularly limited, and the sacrificial film may be removed through wet etching and/or chemical physical polishing. Preferably, the sacrificial film may be removed through wet etching, and in this case, a composition of an etchant may be varied according to a type of a metal thin film of the sacrificial film.

A method (II) of manufacturing a flexible thermoelectric element according to one embodiment of the present invention may include A) forming a first-first structure in which a first-first sacrificial substrate, a first-first contact thermal conductor layer, a first electrode are sequentially stacked, and a second-first structure in which a second-first sacrificial substrate, a second-first contact thermal conductor layer, and a second-first electrode are sequentially stacked, B) forming a P-type thermoelectric material on a third-first sacrificial substrate and forming an N-type thermoelectric material on a fourth-first sacrificial substrate, C) transferring each of the P-type thermoelectric material and the N-type thermoelectric material to the first-first structure, D) manufacturing a substrate on which thermoelectric material column arrays are formed by physically connecting the second-first structure and the first-first structure to which the P-type thermoelectric material and the N-type thermoelectric material are transferred, E) forming a foam in a void between the thermoelectric material column arrays, and F) removing the first-first sacrificial substrate and the second-first sacrificial substrate.

In the method (II) of manufacturing a flexible thermoelectric element, except that the P-type thermoelectric material and the N-type thermoelectric material are transferred to the first-first structure and then the first-first structure is connected to the second-first structure, all operations may be the same as described in the method (I) of manufacturing a flexible thermoelectric element. That is, forming a contact thermal conductor on a sacrificial substrate, forming an electrode on the contact thermal conductor, forming a thermoelectric material (the forming is the same except that a lower base material is different, and the third-first sacrificial substrate and the fourth-first sacrificial substrate may be any one selected from the materials listed in the first sacrificial substrate and the third-first sacrificial substrate and the fourth-first sacrificial substrate may be the same or different from each other), forming a filling material, and removing a sacrificial substrate are the same as those described in the method (I) of manufacturing a flexible thermoelectric element, and thus detailed description thereof will be omitted.

The operation C) according to one embodiment may be an operation of transferring each of the P-type thermoelectric material and the N-type thermoelectric material to the first-first structure. Specifically, the P-type thermoelectric material and the N-type thermoelectric material formed at each of the third-first sacrificial substrate and the fourth-first sacrificial substrate may be transferred to the first-first structure. The transferring method may be used without particular limitation as long as it is commonly used in the art.

Next, the operation D) of manufacturing the substrate on which the thermoelectric material column arrays are formed by physically connecting the second-first structure and the first-first structure to which the P-type thermoelectric material and the N-type thermoelectric material are transferred may be performed. As described above, the second-first structure and the first-first structure to which the P-type thermoelectric material and the N-type thermoelectric material are transferred may be connected to space the thermoelectric materials from each other, and as shown in FIG. 2, the second-first structure and the first-first structure may be connected to alternately dispose the P-type thermoelectric material and the N-type thermoelectric material. For example, the above-described connection may be performed through bonding, and the bonding method is not particularly limited as long as it is capable of bonding the electrode and the thermoelectric material, and for example, bonding may be performed using a conductive adhesive. As an example, the conductive adhesive may be a silver paste containing silver, and as a specific example, a silver (Ag) paste, a tin-silver (Sn-Ag) paste, a tin-silver-copper (Sn-Ag-Cu) paste, or a tin-antimony (Sn-Sb) paste may be used, but the present invention is not limited thereto.

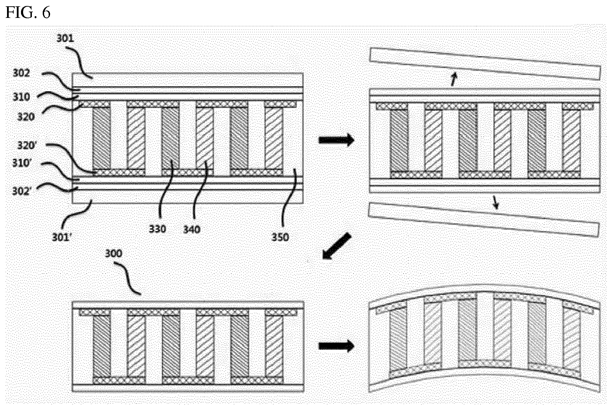

FIG. 6 is a photograph illustrating an example in which the flexible thermoelectric element according to one embodiment of the present invention is applied in a real life situation. The flexible thermoelectric element may be applied to objects of various shapes. Referring to FIG. 6, the flexible thermoelectric element according to the present invention is capable of power generation using body heat generated in a human body. As an example, thermoelectric generation may be possible by being applied to a human arm.

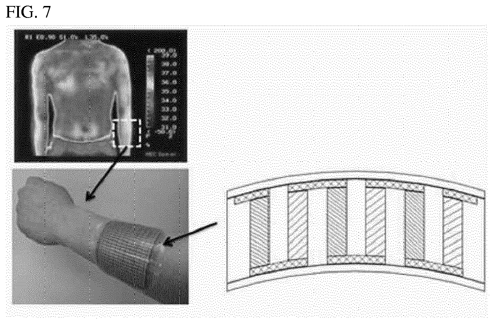

FIG. 7 is a photograph illustrating another example in which the flexible thermoelectric element according to one embodiment of the present invention is applied in a real life situation. Referring to FIG. 7, the flexible thermoelectric element according to the present invention can be applied to a part in the presence of heat or where cooling is needed, such as an automobile, a ship, a windshield, a smart phone, an airplane, or a power plant. Generally, since objects have arbitrary shapes, the flexible thermoelectric element according to the present invention has an advantage in being capable of being applied to objects of various shapes. Further, since the flexible thermoelectric element may match a shape of an application portion and be in direct contact with the application portion, heat transfer efficiency may be improved and thus performance of the thermoelectric element may be maximized with respect to an applied object. Furthermore, since the flexible thermoelectric element may be manufactured using a thin insulating layer with high thermal conductivity, higher thermoelectric efficiency may be achieved in comparison to using a conventional alumina ($Al_2O_3$) substrate.

The flexible thermoelectric element and a production method thereof according to the present invention will be described in more detail below with reference to the following examples. It should be understood, however, that the following examples are merely illustrative, and the present invention is not limited thereto, and the present invention may be implemented in various forms. Unless otherwise defined, all technical and scientific terms have the same meanings as commonly understood by one skilled in the art to which the present invention pertains. Terms used herein are merely intended to effectively describe a specific example and are not intended to limit the present invention. Further, the singular forms used in this disclosure and the appended claims are intended to include the plural forms, unless the context clearly indicates otherwise. Furthermore, a unit of an additive may be wt% unless specifically described in this disclosure.

[Example 1]

The flexible thermoelectric element cannot maintain a shape thereof without a filler because the filler should be manufactured in the form of supporting a copper electrode and a thermoelectric material in the flexible thermoelectric element. Therefore, in order to determine a variation in thermoelectric performance index of the thermoelectric element according to change of the filler, the thermoelectric performance indexes before and after filling with the filler in a commercially available element with a substrate were measured and the variation was determined. The commercially available element used in this experiment is a SP1848-27145 model of Shenzhen Eshinede Technology Company of China. $ZT_{air}$ of the thermoelectric element was measured using the Haman method before filling with the filling material in the thermoelectric element, and a value of $ZT_{air}$ was 0.678 $K^{-1}$.

Next, in order to form a polyurethane foam which is the filling material, a curing agent (part A), which is Flexfoam-iT X of Smooth-On, Incorporated, and a main material (B) were weighed and mixed in a volume ratio of 1 to 1. This mixed solution was poured into a mold containing a commercially available thermoelectric element at room temperature to uniformly fill an interior of the commercially available thermoelectric element. After filling for about 5 minutes, a urethane foam was dried in an oven at a temperature of 60 °C for 10 minutes to be completely cured and foamed, and then the remaining portions except for the polyurethane foam filling inside the commercially available thermoelectric element were removed to complete the filling of the interior of the commercially available thermoelectric element. $ZT_{filler}$ of the commercially available thermoelectric element filled with the polyurethane foam was measured and the value of $ZT_{filler}$ was 0.633 $K^{-1}$, and a ZT variation was 6.6% in comparison with a measurement taken before the filling of the filling material.

[Example 2]

A commercially available thermoelectric element, the same as in Example 1, was used and a characteristic of the commercially available thermoelectric element was evaluated by changing the filling material to a silicone-based foam. At this point, in order to form the silicone-based foam as the filling material, a main material (part A), which is Soma Foama 15 of Smooth-On, Incorporated, and a curing agent (part B) were weighed and mixed at a volume ratio of 2 to 1.

The manufactured thermoelectric element had a low ZT value and high adhesive strength between the silicone foam and the electrode, but the silicone foam had slightly low physical strength and thus there is a disadvantage in that the silicone foam may be torn.

[Example 3]

In the manufacturing of the flexible thermoelectric element using the polyurethane foam as the filling material, the thermoelectric material was formed through screen printing and a thermoelectric performance index was determined by comparing with the results of Examples 1 and 4.

Two silicone oxide substrates (4-inch wafers), each of which has a Si layer formed as a sacrificial substrate were provided. Next, a copper film electrode having a thickness of about 30 $\mu$m was formed on each of the two substrates on which an aluminum nitride film was formed. Next, a P-type thermoelectric material or an N-type thermoelectric material was formed on an electrode of each of the two substrates on which the electrode is formed (hereinafter, for convenience of description, the electrode in which the P-type thermoelectric material is formed is referred to as a first electrode, and the electrode in which the N-type thermoelectric material is formed is referred to as a second electrode).

Specifically, a P-type thermoelectric material paste was applied to a predetermined region of the first electrode through screen printing and underwent heat treatment to form the P-type thermoelectric material. At this point, the P-type thermoelectric material paste was prepared by mixing 84.5 wt% $Bi_{0.3}Sb_{1.7}Te_3$ powder, 12.8 wt% (binder + solvent) (7SVB-45), and 2.7 wt% glass frit ($Bi_2O_3$, $Al_2O_3$, $SiO_3$, ZnO), and in the case of heat treatment, the solvent was removed after 10 minutes at a temperature of 100 °C, heat treatment was performed at a temperature of 250 °C for 30 minutes to remove the binder, and annealing was performed at a temperature of 550 °C for 80 minutes.

An N-type thermoelectric material paste was applied to a predetermined region of the second electrode through screen printing and underwent heat treatment to form the N-type thermoelectric material. At this point, the N-type thermoelectric material paste was manufactured by mixing 84.5 wt% $Bi_xTe_{1-x}$ powder, 12.8 wt% (binder + solvent) (7SVB-45), and 2.7 wt% glass frit ($Bi_2O_3$, $Al_2O_3$, $SiO_3$, and ZnO), and in the case of heat treatment, the solvent was removed after 10 minutes at a temperature of 100 °C, heat treatment was performed at a temperature of 250 °C for 30 minutes to remove the binder, and annealing was performed at a temperature of 510 °C for 90 minutes. Next, as shown in FIG. 2, the substrate on which the P-type thermoelectric material was formed and the substrate on which the N-type thermoelectric material was formed were bonded using a silver paste to manufacture a substrate having thermoelectric material column arrays.

Subsequently, in order to form the polyurethane foam as the filling material, a main material (part A), which is FlexFoam-iT X of Smooth-On, Incorporated, and a curing agent (part B) were weighed and mixed in a volume ratio of 1 to 1. This mixture was poured into a mold containing a flexible thermoelectric element, uniformly filled in the thermoelectric element, was foamed and cured. After filling for about 5 minutes, the urethane foam was dried in an oven at a temperature of 60 °C for 10 minutes to be completely cured, and then the remaining portions except for the polyurethane foam filling inside the thermoelectric element were removed to form the flexible thermoelectric element.

Finally, the silicone thin film formed on the substrate was peeled off using laser delamination, and the $Si/SiO_2$ layer remaining outside the flexible thermoelectric element was removed with a mixed solution of $HNO_3$, $H_2O$, and HF (10 volume%: 75 volume%: 15 volume% respectively) to manufacture the flexible thermoelectric element.

The inner filling material of the manufactured flexible thermoelectric element had very low thermal conductivity and thus the manufactured flexible thermoelectric element exhibited high thermoelectric efficiency as the flexible thermoelectric element manufactured through screen printing, and adhesive strength and mechanical stability between the polyurethane foam and the electrode were high.

[Example 4]

A flexible thermoelectric element was manufactured using a bulk thermoelectric material and a polyurethane foam which were commercially available in the market as a filling material, and Whether similar thermoelectric performance characteristics were exhibited in a flexible thermoelectric element structure was determined by comparing the results to the results of Examples 1 and 3.

A first electrode and a second electrode were formed through the same method as in Example 3, a P-type bulky thermoelectric material and an N-type bulky thermoelectric material were respectively bonded to the first electrode and the second electrode using a silver paste as a designed pattern, a substrate on which the P-type thermoelectric material was formed and a substrate on which the N-type thermoelectric material was formed were bonded to each other to manufacture a substrate having thermoelectric material column arrays formed therein.

The forming and filling of the polyurethane foam formation were performed by weighing and mixing a main material (part A), which was FlexFoam-iT X of Smooth-On, Incorporated, and a curing agent (part B) in a volume ratio of 1 to 1. The mixed solution was poured into a mold containing the flexible thermoelectric element at room temperature to uniformly fill an interior of the flexible thermoelectric element. After filling for about 5 minutes and the urethane foam being dried in an oven for 10 minutes to be completely cured, the remaining portions except for the polyurethane foam filled inside the thermoelectric element were removed to form the flexible thermoelectric element. The substrate supporting the flexible thermoelectric element was removed by a physical method before the filling of the filling material was completed, thereby manufacturing the flexible thermoelectric element.

[Comparative Example 1]

A commercially available thermoelectric element was used the same as in Example 1, and a characteristic of the commercially available thermoelectric element was evaluated by changing the filling material to urethane-based rubber. At this point, in order to form the urethane-based rubber as a filling material, a main material (part A), which is vytaFlex 30 of Smooth-On, Incorporated, and a curing agent (part B) were weighed and mixed in a volume ratio of 1 to 1, the mixture filled in a void between thermoelectric material column arrays and was cured to form the filling material.

The manufactured thermoelectric element had a problem in that thermal conductivity of the filling material was high and thus thermoelectric efficiency was degraded.

[Comparative Example 2]

A commercially available thermoelectric element, the same as in Example 1, was used, and a characteristic of the commercially available thermoelectric element was evaluated by changing the filling material to silicone-based rubber. At this point, in order to form the silicone-based rubber as a filling material, a main material (part A), which is Ecoflex 0010 of Smooth-On, Incorporated, and a curing agent (part B) were weighed and mixed in a volume ratio of 1 to 1, the mixture filled in a void between thermoelectric material column arrays and was cured to form the filling material.

Thermal conductivity of the manufactured thermoelectric element was slightly high, and adhesive strength between the electrode and the silicone-based rubber was low and thus mechanical stability of the manufactured thermoelectric element was degraded.

[Comparative Example 3]

A commercially available thermoelectric element, the same as in Example 1, was used and a characteristic of the commercially available thermoelectric element was evaluated by changing the filling material to silicone-based rubber. In this case, polydimethylsiloxane (Sylgard® 184 of Dow Corning Corporation) was used as a precursor of the silicone-based rubber, filled in a void between the thermoelectric material column arrays and was cured to form the filling material.
The manufactured thermoelectric element had high adhesive strength, but thermal conductivity of the filling material was slightly high and flexibility and tensile strength were low.

[Comparative Example 4]

In order to form the silicone-based rubber as a filling material, a main material (part A), which was Ecofle 0010 of Smooth-On, Incorporated, and a curing agent (part B) were weighed and mixed in a volume ratio of 1 to 1, the mixed solution was mixed with silica aerogel in a volume ratio of 2 to 1, and the mixture filled in a void between thermoelectric material column arrays and was cured to form the filling material.
Thermal conductivity of the manufactured thermoelectric element was slightly low and adhesive strength and physical strength were significantly degraded due to the silica aerogel, and thus the thermoelectric element could not maintain a shape thereof when the ceramic substrate was removed.

[Comparative Example 5]

A substrate on which a P-type thermoelectric material was formed and a substrate on which an N-type thermoelectric material was formed were manufactured in the same method as in Example 4.
Next, a main material (part A), which was vytaFlex 30 of Smooth-On, Incorporated, and a curing agent (part B) were weighed and mixed in a volume ratio of 1 to 1 and then the mixture was coated and cured on the electrode of each of the substrates, wherein the filling material was formed to have a height 1/5th of that of a thermoelectric material column.
The manufactured thermoelectric elements exhibited low thermal conductivity because the filling material was not completely filled, and the filling material was not entirely connected, and the electrode and only a portion of the thermoelectric material were bonded by the filling material, and thus adhesive strength and physical strength were significantly degraded, such that the thermoelectric element could not maintain a shape thereof when the ceramic substrate was removed.

[Characteristic Evaluation]

1) Thermal conductivity (W/m.K): this was calculated with specific heat $\times$ thermal diffusion coefficient $\times$ density.
Specific heat: an input difference of energy required for maintaining a temperature difference between a specimen and a reference material at zero was measured with a function of time and temperature by varying temperatures of the specimen and the reference material through a program (differential scanning calorimetry).
Thermal diffusivity: this was measured by detecting a temperature rise at a rear surface of the specimen according to time by an infrared detector (IR detector) while uniformly heating a front surface of the specimen using an instantaneous flash of a laser beam (Laser Flash method).
Density: this was measured by measuring a weight and an apparent volume of the specimen and dividing the weight by the apparent volume.
2) Thermoelectric performance index (ZT and $K^{-1}$): this was measured by applying a square wave current to the thermoelectric element and measuring a voltage generated from the thermoelectric material due to the applied current (according to the Harman method that is commonly used). $ZT_{air}$ is a thermoelectric performance index before filling the foam, and $ZT_{filler}$ is a thermoelectric performance index after forming the foam.

$$- ZT \text{ variation } (\%) = (ZT_{air} - ZT_{filler}) / ZT_{air} \times 100$$

3) Adhesive strength (MPa): an adhesive force of the interface being completely peeled off was measured while gradually applying a force to both ends based on the adhesive interface and pulling both of the ends (pull-off test).

4) Porosity (volume%): this was measured inside a material by comparing with a density of the specimen (as a porosity becomes higher, the density of the specimen becomes lower and the porosity may be calculated based on the specimen with a porosity of 0%).

[Table 1]

| | Thermal Conductivity of Filling Material (W/m.K) | $ZT_{air}$ (K$^{-1}$) | $ZT_{filler}$ (K$^{-1}$) | ZT variation (%) | Adhesive Strength (MPa) | Porosity (volume%) |
|---|---|---|---|---|---|---|
| Example 1 | 0.031 | 0.678 | 0.633 | 6.6 | 0.232 | 75 |
| Example 2 | 0.093 | 0.67 | 0.59 | 11.9 | 0.186 | 81 |
| Example 3 | 0.031 | 0.535 | 0.5 | 6.5 | 0.258 | 76 |
| Example 4 | 0.031 | 0.67 | 0.63 | 6.0 | 0.223 | 75 |
| Comparative Example 1 | 0.12-0.18 | 0.66 | 0.56 | 15.2 | 0.201 | <1 |
| Comparative Example 2 | 0.181 | 0.65 | 0.53 | 18.5 | 0.175 | <1 |
| Comparative Example 3 | 0.154 | 0.65 | 0.52 | 20 | 0.265 | <1 |
| Comparative Example 4 | 0.03 | 0.66 | Not measurable | - | Not measurable | Not measurable |
| Comparative Example 5 | 0.025 | - | Not measurable | - | Not measurable | Not measurable |

As shown in Table 1, in Examples 1 to 4 in which the thermoelectric elements were manufactured according to one embodiment of the present invention, when the foamed material was used as the filling material, the thermal conductivity was 0.05 W/m.K or less and was significantly lower than those of Comparative Examples 1 to 4, and specifically, in the case of Example 1, the polyurethane foam having low thermal conductivity as the filler material, and thus a degree of degradation of the thermoelectric performance index before and after filling with the filler material remained at 6.6% and very high thermoelectric efficiency was exhibited, and in the case of Example 4 in which the bulk material was used as the thermoelectric material, a degree of degradation of the thermoelectric efficiency remained at 6.0% and thus high thermoelectric efficiency index was exhibited.

On the other hand, in the case of Comparative Examples 1 to 3, since the foaming was not performed, the polymer material filled all the voids of the thermoelectric element and thus the thermal conductivity was high, and specifically, in Comparative Example 2, since the silicone-based rubber was used as the filling material, the adhesive strength between the electrode and the silicone-based rubber was not good and thus the mechanical stability of the thermoelectric element was degraded.

In the case of Comparative Example 4, the thermal conductivity was slightly low, and the adhesive strength and the physical strength were degraded due to the aerogel, and thus the thermoelectric element could not maintain a shape thereof when the ceramic substrate was removed.

In the case of Comparative Example 5, since the filling material was not completely filled, air was introduced into the filling material to exhibit low thermal conductivity, and the filling material was not entirely connected and was adhered to the electrode and a portion of the thermoelectric material, such that the adhesive strength and the physical strength were degraded and the thermoelectric element could not maintain a shape thereof when the ceramic substrate was removed,

While the preferred embodiments of the present invention have been described, it is noted that various alternations, modifications, and equivalents may be applied to the present invention and the preferred embodiments may be appropriately modified and applied thereto. Therefore, the above description is not intended to limit the scope of the present invention defined by the appended claims.

**Claims**

1. A flexible thermoelectric element, comprising:

   a thermoelectric material column array including one or more N-type thermoelectric material and one or more P-type thermoelectric material which are spaced apart from each other;
   an electrode configured to electrically connect the thermoelectric materials of the thermoelectric material column array; and
   a foam configured to fill in at least a void of the thermoelectric material column array.

2. The flexible thermoelectric element of claim 1, wherein the foam has a porosity in a range of 50 to 98 percent by volume.

3. The flexible thermoelectric element of claim 1, wherein the foam has thermal conductivity of 0.1 W/m.K or less.

4. The flexible thermoelectric element of claim 1, wherein the foam is formed by foaming a polymer or a prepolymer.

5. The flexible thermoelectric element of claim 4, wherein the foam includes a polyurethane-based foam, a silicone-based foam, or a polyolefin-based foam.

6. The flexible thermoelectric element of claim 1, wherein the electrode includes a glass frit.

7. A production method for a flexible thermoelectric element, comprising:

   a) forming a first structure in which a first sacrificial substrate, a first contact thermal conductor layer, a first electrode, and a P-type thermoelectric material formed at a predetermined region on the first electrode are sequentially stacked, and a second structure in which a second sacrificial substrate, a second contact thermal conductor layer, a second electrode, and an N-type thermoelectric material formed at a predetermined region on the second electrode are sequentially stacked;
   b) manufacturing a substrate having the thermoelectric material column arrays formed by physically connecting the first structure and the second structure;
   c) forming a foam in a void between the thermoelectric material column arrays of the substrate; and
   d) removing the first sacrificial substrate and the second sacrificial substrate.

8. The method of claim 7, wherein the operation c) includes:

   c-1) filling the void with a foam precursor between the thermoelectric material column arrays of the substrate; and
   c-2) curing and foaming the foam precursor to form the foam.

9. The method of claim 8, wherein the foam precursor contains a polymer or prepolymer and a foaming agent.

10. The method of claim 9, wherein the foaming agent includes a hydrocarbon-type compound, a nitroso-type compound, an azo-type compound, an azide-type compound, an inorganic-based foaming agent, or water.

11. The method of claim 10, wherein the foam includes a polyurethane-based foam, a silicone-based foam, or a polyolefin-based foam.

FIG. 1

FIG. 2

FIG. 3

250

FIG. 4

NON-FOAMING FILLER | FOAMING FILLER

COMPARATIVE EXAMPLE 3 | EXAMPLE 1

FIG. 5

FIG. 6

FIG. 7

## INTERNATIONAL SEARCH REPORT

| International application No. |
|---|
| **PCT/KR2016/012059** |

**A. CLASSIFICATION OF SUBJECT MATTER**

*H01L 35/12(2006.01)i, H01L 35/32(2006.01)i, H01L 35/02(2006.01)i, H01L 35/30(2006.01)i*

According to International Patent Classification (IPC) or to both national classification and IPC

**B. FIELDS SEARCHED**

Minimum documentation searched (classification system followed by classification symbols)
H01L 35/12; H01L 35/02; H01L 35/04; H01L 35/34; H01L 35/32; H01L 35/30

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: flexible thermoelectric device, foaming body, polymer, electrode, filling, sacrificial
substrate

**C. DOCUMENTS CONSIDERED TO BE RELEVANT**

| Category* | Citation of document, with indication, where appropriate, of the relevant passages | Relevant to claim No. |
|---|---|---|
| X | KR 10-2013-0091847 A (PUSAN NATIONAL UNIVERSITY INDUSTRY-UNIVERSITY COOPERATION FOUNDATION) 20 August 2013 See paragraphs [0015]-[0034]; and figures 1-4. | 1-11 |
| A | KR 10-1493797 B1 (KOREA ADVANCED INSTITUTE OF SCIENCE AND TECHNOLOGY) 17 February 2015 See paragraphs [0024]-[0031], [0038]; claims 1-7; and figures 2, 3. | 1-11 |
| A | KR 10-1075772 B1 (SAMSUNG ELECTRO-MECHANICS CO., LTD.) 26 October 2011 See paragraphs [0025]-[0045]; claim 1; and figure 1. | 1-11 |
| A | KR 10-2007-0046233 A (WONKWANG UNIVERSITY CENTER FOR INDUSTRY-ACADEMY COOPERATION) 03 May 2007 See paragraphs [0038]-[0055]; claim 1; and figures 4, 4a. | 1-11 |
| A | KR 10-2014-0123705 A (PTCTECH CO., LTD.) 23 October 2014 See paragraphs [0042]-[0046]; and figures 3, 4 | 1-11 |

| ☐ Further documents are listed in the continuation of Box C. | ☒ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 08 FEBRUARY 2017 (08.02.2017) | **08 FEBRUARY 2017 (08.02.2017)** |

| Name and mailing address of the ISA/KR | Authorized officer |
|---|---|
| Korean Intellectual Property Office Government Complex-Daejeon, 189 Seonsa-ro, Daejeon 302-701, Republic of Korea | |
| Facsimile No. 82-42-472-7140 | Telephone No. |

Form PCT/ISA/210 (second sheet) (January 2015)

INTERNATIONAL SEARCH REPORT
Information on patent family members

International application No.

**PCT/KR2016/012059**

| Patent document cited in search report | Publication date | Patent family member | Publication date |
|---|---|---|---|
| KR 10-2013-0091847 A | 20/08/2013 | KR 10-1351683 B1 | 16/01/2014 |
| KR 10-1493797 B1 | 17/02/2015 | CN 104756269 A | 01/07/2015 |
| | | JP 2016-500201 A | 07/01/2016 |
| | | US 2016-0056360 A1 | 25/02/2016 |
| | | WO 2015-056855 A1 | 23/04/2015 |
| KR 10-1075772 B1 | 26/10/2011 | JP 2012-049546 A | 08/03/2012 |
| | | US 2012-0049315 A1 | 01/03/2012 |
| KR 10-2007-0046233 A | 03/05/2007 | NONE | |
| KR 10-2014-0123705 A | 23/10/2014 | KR 10-1461219 B1 | 18/11/2014 |

Form PCT/ISA/210 (patent family annex) (January 2015)

**EP 3 370 270 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 101646366
- KR 101493797